Europäisches Patentamt

European Patent Office

Office européen des brevets

(11) Veröffentlichungsnummer: **0 202 351**
**B1**

# EUROPÄISCHE PATENTSCHRIFT

(45) Veröffentlichungstag der Patentschrift:
25.10.89

(51) Int. Cl.⁴: **H 05 K 13/04**, B 23 K 1/00,
**H 05 K 3/34**

(21) Anmeldenummer: **85106240.6**

(22) Anmeldetag: **21.05.85**

(54) **Vorrichtung zum Löten und Entlöten von oberflächenmontierten Bauelementen.**

(43) Veröffentlichungstag der Anmeldung:
**26.11.86 Patentblatt 86/48**

(45) Bekanntmachung des Hinweises auf die Patenterteilung:
**25.10.89 Patentblatt 89/43**

(84) Benannte Vertragsstaaten:
**AT BE CH DE FR GB IT LI LU NL SE**

(56) Entgegenhaltungen:
**DE-A-2 655 773**
**FR-A-2 040 681**
**GB-A-1 401 116**
**US-A-4 034 202**
**US-A-4 295 596**

(73) Patentinhaber: **Cooper Industries Inc., P.O. Box 4446, Houston Texas 77210 (US)**

(72) Erfinder: **Goerlich, Peter, Paulinenstrasse 10, D-7121 Walheim (DE)**
Erfinder: **Rittmann, Günther, Mozartweg 8, D-7121 Gemmrigheim (DE)**
Erfinder: **Munz, Volker, Besigheimer Strasse 65, D-7125 Kirchheim/Neckar (DE)**

(74) Vertreter: **Feldkamp, Rainer, Dipl.- Ing., Patentanwälte Wallach, Koch Dr. Haibach, Feldkamp Postfach 920, D-8000 München 33 (DE)**

EP 0 202 351 B1

LIBER, STOCKHOLM 1989

## Beschreibung

Die Erfindung bezieht sich auf eine Vorrichtung zum Löten und Entlöten von oberflächenmontierten Bauelementen auf Leiterplatten, Hybridschaltungen und dergleichen, mit Hilfe eines Heißluftstroms, siehe z. B. die US-A-4 295 596.

Es ist bereits bekannt, sehr kleine Bauelemente mit Hilfe eines Heißluft- oder Heißgasstromes zu verlöten, da dieser Heißluft- oder Heißgasstrom präzise auf vorgegebene Bereiche eines Bauelementes gerichtet werden kann, ohne daß andere Bereiche des Bauelementes unzulässig erwärmt werden. Ein derartiges Lötgerät ist insbesondere zur Befestigung von oberflächenmontierten elektronischen Bauelementen, wie z. B. Chip-Kondensatoren, Transistoren, Flat-Pack-ICs und dergleichen, geeignet. Diese Bauteile werden zumeist mit Hilfe einer an dem Lötgerät befestigten oder einer getrennten Klemmpinzette auf die Leiterplatte aufgesetzt und dann verlötet. Hierbei hat es sich teilweise als schwierig erwiesen, sehr kleine Bauteile zuverlässig an ihren Platz zu bringen und während des Lötvorganges und bis zum Erkalten des Lotes sicher an ihrem Platz auf der Leiterplatte festzuhalten.

Der Erfindung liegt die Aufgabe zugrunde, eine Vorrichtung der eingangs genannten Art zu schaffen, die ein zuverlässiges und schnelles Befestigen selbst sehr kleiner Bauelemente an einer Leiterplatte oder dergleichen ohne Gefahr einer Beschädigung dieser Bauelemente ermöglicht.

Diese Aufgabe wird durch die im kennzeichnenden Teil des Patentanspruchs 1 angegebenen Merkmale gelöst.

Vorteilhafte Ausgestaltungen und Weiterbildungen der Erfindung ergeben sich aus den Unteransprüchen.

Durch die erfindungsgemäße Ausgestaltung der Vorrichtung kann ein auf einer Leiterplatte oder dergleichen zu befestigendes Bauteil mit Hilfe der Vakuumpinzette sicher festgehalten werden, wobei der Abstand zwischen der mindestens einen Heißluftdüse und dem Mittelpunkt der Vakuumpinzette einstellbar ist, um Bauelemente unterschiedlicher Größen befestigen zu können.

Nach einer präzisen Ausrichtung des Kopfes und damit des von der Vakuumpinzette gehaltenen Bauelementes über der Leiterplatte oder dergleichen kann dann der Kopf abgesenkt werden und ein Heißluft- oder Heißgasstrom durch die Heißluftdüse geleitet werden, um den Lötvorgang durchzuführen.

Zur Beschleunigung des Lötvorganges kann hierbei vorgesehen sein, daß die Leiterplatte oder dergleichen auf einer Heizplatte oder unter einem Infrarot-Heizer angeordnet ist, um den zu lötenden Bereich auf eine Temperatur vorzuwärmen, die unterhalb der Löttemperatur liegt.

Damit braucht der Heißluft- oder Heißgasstrom lediglich die restliche Wärmeenergie zum Schmelzen des Lotes zuzuführen.

Gemäß einer bevorzugten Ausgestaltung der Erfindung ist vorgesehen, daß die Vakuumpinzette mit Hilfe einer Antriebseinrichtung um ihre Längsachse drehbar ist. Auf diese Weise kann eine genaue Ausrichtung der jeweiligen Bauelemente gegenüber den Heißluftdüsen erzielt werden, wobei auch gegebenenfalls der gesamt Kopf um eine vertikale Achse drehbar ist, um eine exakte Ausrichtung gegenüber der Leiterplatte zu erzielen.

Die Vakuumpinzette kann weiterhin in Vertikalrichtung gegenüber dem Kopf und den mit diesem verbundenen Heißluftdüsen nach unten hin elastisch vorgespannt sein, so daß das Bauelement fest gegen die Leiterplatte angedrückt wird.

Zur Befestigung von Bauelementen mit sich an gegenüberliegenden Seiten des Bauelementes erstreckenden Anschlüssen sind vorzugsweise zwei symmetrisch auf beiden Seiten der Vakuumpinzette angeordnete Heißluftdüsen vorgesehen, wobei es selbstverständlich auch möglich ist, bei Bauelementen, die an allen vier Seitenkanten Anschlüsse aufweisen, vier Heißluftdüsen symmetrisch um die Vakuumpinzette herum anzuordnen.

Gemäß einer weiteren bevorzugten Ausgestaltung der Erfindung ist der heb- und drehbare Kopf der Vorrichtung an einem Tragarm befestigt, der aus zwei um eine erste vertikale Schwenkachse gegeneinander verschwenkbaren Abschnitten besteht, wobei das freie Ende des ersten Abschnitts an einer höhenverstellbaren Halterung um eine zweite Schwenkachse schwenkbar befestigt ist, während das freie Ende des zweiten Abschnittes den Kopf über eine drehbare Welle trägt. Durch eine entsprechende Antriebseinrichtung an dem Arm und dem Kopf kann dafür gesorgt werden, daß sich eine exakte Parallelführung des Kopfes bei einem Verschwenken des Armes ergibt. Auf diese Weise kann der Kopf zwischen einem Bauelement-Vorratsbereich und einem Arbeitsbereich (der Leiterplatte) verschwenkbar sein, so daß die Vorrichtung Bauelemente aus einem Vorratsbehälter aufnehmen und auf der Leiterplatte oder dergleichen absetzen und befestigen kann.

Zur Befestigung von Bauelementen mit sich entlang einer Kante erstreckenden Anschlüssen ist die Austrittsöffnung der Heißluftdüse in einer Richtung langgestreckt, die senkrecht zur Verbindungslinie zwischen der Heißluftdüse und der Vakuumpinzette verläuft, und der der Vakuumpinzette zugewandte Rand der Austrittsöffnung ist hierbei vorzugsweise durch einen Auflagesteg nach unten hin verlängert. Dieser Auflagesteg kann dann zum Andrücken der Anschlüsse des Bauelementes gegen die Leiterplatte verwendet werden, wobei dieser Auflagesteg die Anschlüsse bis zum Erkalten des Lotes festhält.

Zusätzlich ergibt sich hierbei der Vorteil, daß der Hauptteil des Bauelementes gegenüber dem Heißluftstrom geschützt wird, so daß dieser Hauptteil des Bauelementes nur geringfügig beim Lötvorgang erwärmt wird.

Der Auflagesteg ist vorzugsweise für Lot unbenetzbar und schlecht wärmeleitend, um eine Wärmeabfuhr von der Lötstelle zu verhindern. Weiterhin sollte er eine geringe Wärmespeicherkapazität aufweisen.

Wenn die Vorrichtung mit einem geteilten Schwenkarm versehen ist, kann weiterhin eine automatische Steuerung des Erfassens eines Bauelementes in einem Vorratsbehälter, der Bewegung des Bauelementes zu einer Leiterplatte in dem Arbeitsbereich und des Absenkens und Befestigens des Bauelementes auf der Leiterplatte in dem Arbeitsbereich durchgeführt werden.

Hierbei kann selbstverständlich auch die Hubbewegung des Kopfes automatisch gesteuert werden.

Die Erfindung wird im folgenden anhand von in der Zeichnung dargestellten Ausführungsbeispielen noch näher erläutert.

In der Zeichnung zeigen.

Figur 1   eine teilweise geschnittene vertikale Ansicht des Kopfes,

Figur 2   eine teilweise geschnittene Ansicht einer Einzelheit der Befestigung des Kopfes an einem Tragarm,

Figur 3   eine Ausführungsform eines geteilten schwenkbaren Tragarms,

Figur 4   eine ausführlichere Ansicht der unteren Enden von zwei Heißluftdüsen sowie der Vakuumpinzette,

Figur 5   eine perspektivische Ansicht eines auf einer Leiterplatte angeordneten Bauelementes mit darüber angeordneter Heißluftdüse.

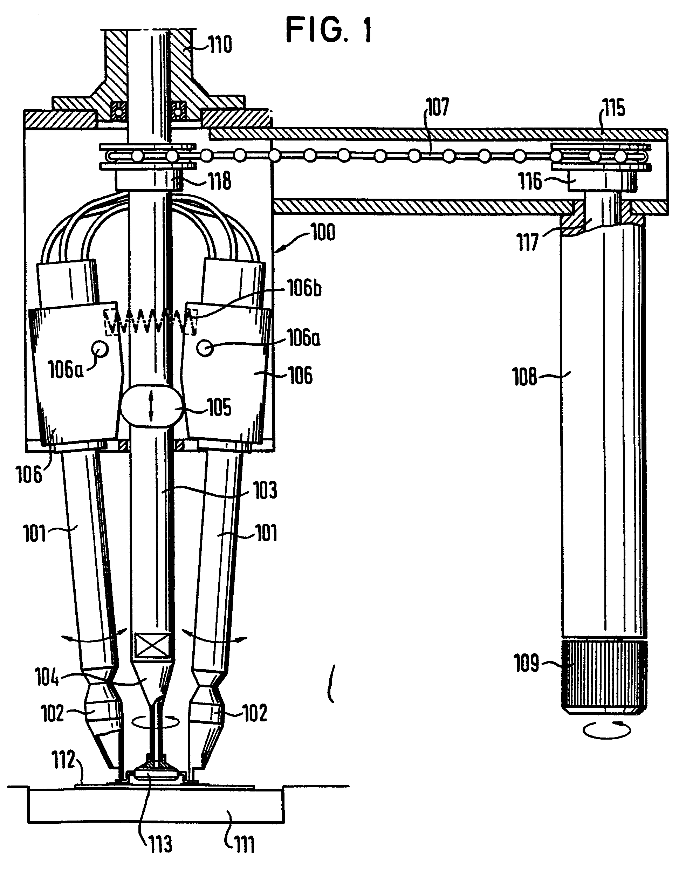

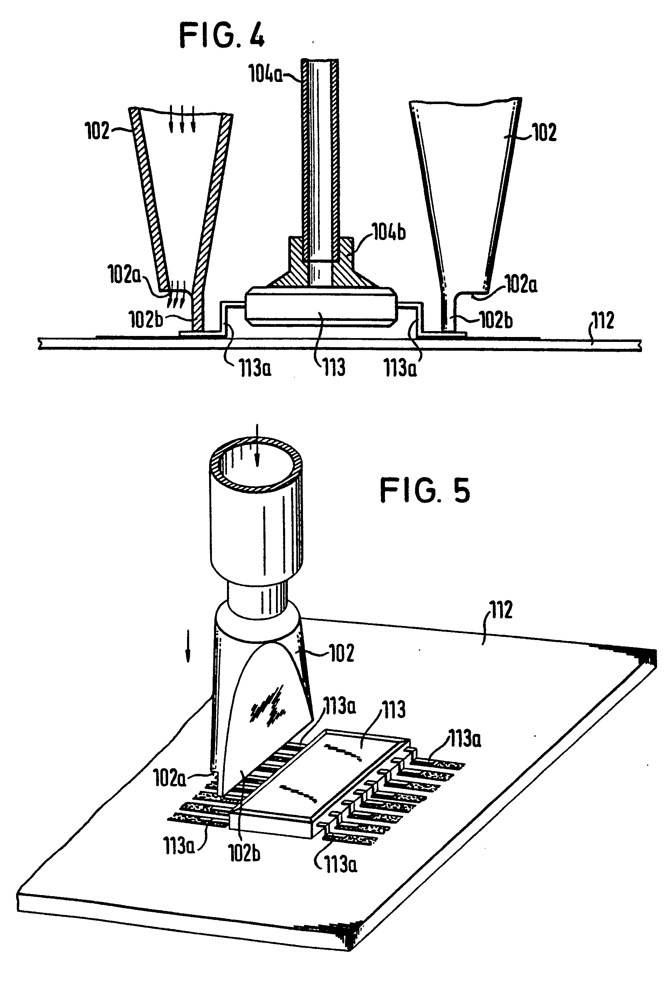

In Figur 1 ist eine Ausführungsform eines Kopfes 100 dargestellt, der an seinem unteren Ende zwei Heißluftdüsen 101, 102 sowie eine Vakuumpinzette 103, 104 trägt. Einzelheiten der unteren Enden 102 der Heißluftdüsen sowie der Vakuumpinzette 104 sind in Figur 4 dargestellt.

In Figur 1 ist weiterhin eine Heizplatte 111 gezeigt, die eine Leiterplatte 112 (oder eine Hybridschaltung) auf eine Temperatur vorwärmt, die unterhalb der Löttemperatur liegt. Die Leiterplatte kann auf der Heizplatte 111 mit Hilfe von Vakuum angesaugt werden, wobei eine entsprechende Vakuumpumpe über einen Schiebeschalter an der Heizplatte ein- und ausgeschaltet wird. Die Oberfläche der Heizplatte 111 kann zur Verringerung des Wärmerückflusses beim Lötvorgang mit Teflon beschichtet sein oder Aussparungen aufweisen.

Ein auf der Leiterplatte 112 zu befestigendes Bauelement 113 mit aus Figur 4 ersichtlichen Anschlüssen 113a ist am unteren Ende einer Vakuumpinzette 103, 104 befestigt, und die unteren Enden der Heißluftdüsen sind mit einem Auflagesteg 102b in der aus Figur 4 ersichtlichen Weise ausgebildet, der die Anschlüsse des Bauelementes 113 fest gegen die Leiterplatte drückt.

Die trotz der Vorwärmung auf der Heizplatte noch erforderliche Wärmeenergie zum Schmelzen des Lotes wird durch erhitztes Schutzgas oder Luft zugeführt. Im folgenden wird zur Vereinfachung in diesem Zusammenhang lediglich von Heißluft gesprochen, doch soll dieser Ausdruck auch irgendein inertes Gas oder dergleichen einschließen. Die Heißluft wird in zwei oder mehreren Heißluftdüsen 101, 102 erhitzt, wobei sich die Anzahl der Heißluftdüsen nach der Anzahl der Seiten des Bauelementes richtet, an denen Anschlüsse angeordnet sind, die gleichzeitig verlötet werden sollen. Bei der Ausführungsform nach den Figuren 1, 4 und 5 weist das Bauelement 113 zwei gegenüberliegende Anschlußreihen an gegenüberliegenden Seiten auf, doch sind genauso Bauelemente denkbar, die an allen vier Seitenkanten Anschlüsse aufweisen, so daß vier um eine Vakuumpinzette herum angeordnete Heißluftdüsen vorgesehen werden würden.

Zur Anpassung an die zu befestigenden Bauelemente können die Heißluftdüsen unterschiedlich geformt sein. Der Auflagesteg verhindert, daß das Bauelement 113 selbst von der Heißluft unzulässig erwärmt wird und andererseits drückt dieser Auflagesteg selbst leicht verformte Anschlüsse der Bauelemente sicher an die Leiterplatte und hält sie nach dem Lötvorgang bis zum Erstarren des Lotes fest.

Wie aus Figur 1 zu erkennen ist, sind die oberen Enden der Heißluftdüsen 101, 102 in Schwenkkörpern 106 gehalten, die um Schwenkachsen 106a verschwenkbar sind. Zwischen den Schwenkkörpern ist oberhalb der Schwenkachsen 106a eine Druckfeder 106b angeordnet, während unterhalb der Schwenkachsen ein Verstellteil 105 angeordnet ist, das mit konisch ausgebildeten Nockenflächen an den Schwenkkörpern 106 zusammenwirkt, um den Abstand der unteren Enden der Heißluftdüsen voneinander zu ändern.

Die Vakuumpinzette ist in dem Kopf 100 drehbar gelagert und trägt eine Riemenscheibe 118, die über einen Riemen 107 mit einer weiteren Riemenscheibe 116 verbunden ist, die in einem an dem Kopf 100 befestigten Arm 115 gelagert ist. Eine Achse 117 der Riemenscheibe 116 erstreckt sich durch einen an dem Arm 115 befestigten Handgriff 108 hindurch und endet in einem drehbaren Betätigungsknopf 109, der gedreht werden kann, um die Ausrichtung des von der Vakuumpinzette gehaltenen Bauelementes gegenüber den Heißluftdüsen zu ermöglichen. Wie klarer aus Figur 4 zu erkennen ist, endet die Vakuumpinzette 103, 104 in einem sehr engen Rohrabschnitt 104a, an dessen Ende ein Saugnapf 104b befestigt ist, der mit dem Bauelement 113 in Eingriff steht. Die Vakuumpinzette kann vorzugsweise gegenüber dem Kopf und damit den Heißluftdüsen in Axialrichtung nach unten hin vorgespannt sein, um ein sicheres Andrücken des Bauelementes gegen die Leiterplatte vor dem Aufsetzen der Heißluftdüsen zu ermöglichen.

Der gesamte Kopf 100 kann in Vertikalrichtung bewegbar und um eine vertikale Achse drehbar sein, wobei entsprechende Drehbewegungen und Heb- und Senkbewegungen mit Hilfe des Handgriffes 108 oder mit Hilfe einer an sich bekannten automatischen Steuervorrichtung erreicht werden können.

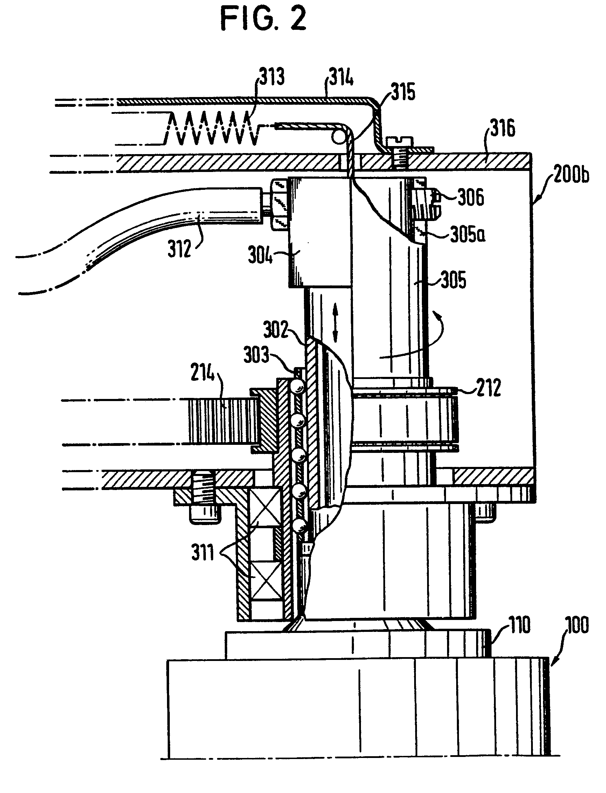

Wie dies in Figur 2 gezeigt ist, ist am oberen Ende des Kopfes 100 ein Befestigungsflansch 110 befestigt, der nach oben hin durch eine Hohlwelle 302 verlängert ist, die ein Vakuumrohr zur Speisung der Vakuumpinzette aufnimmt sowie eine Welle für einen Kugelkäfig 303 bildet, der eine Drehung der Welle 302 sowie eine Heb- und Senkbewegung dieser Welle ermöglicht. Dieser Kugelkäfig 303 ist in einer in einem Tragarm 200b gelagerten Antriebswelle 305 gelagert, wobei diese Antriebswelle ihrerseits in einem den Tragarm 200b bildenden Hohlprofil über Kugellager 311 gelagert ist. Die Antriebswelle 305 weist einen sich in Vertikalrichtung erstreckenden Schlitz 305a auf, in den sich der Kopf einer Zylinderschraube 306 erstreckt, die in die Hohlwelle 302 eingeschraubt ist. Auf diese Weise ist die Hohlwelle 302 drehfest mit der Antriebswelle 305 verbunden, kann sich jedoch gegenüber dieser in Axialrichtung nach oben und unten bewegen. Die Hohlwelle 302 ist weiterhin über ein um eine Umlenkrolle gelegtes Seil 315 und eine Vorspannfeder 313 nach oben hin vorgespannt. Die Feder und das hintere Ende der Schnur 315 sind in einem Federgehäuse 314 geschützt angeordnet.

Mit der Hohlwelle 302 ist weiterhin ein Deckel 304 mit einer Vakuumzuführung 312 verbunden.

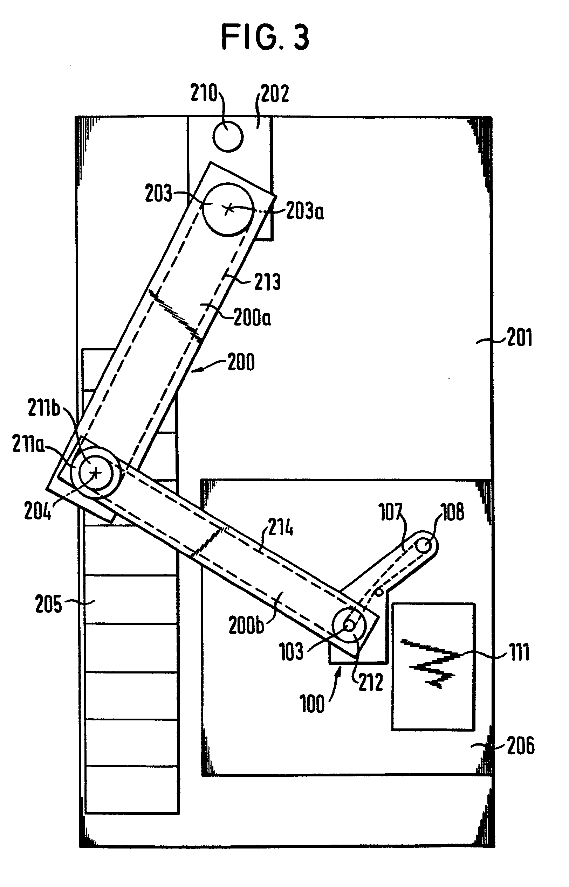

Auf der Antriebswelle 305 ist eine Riemenscheibe 212 angeordnet, die mit einem Riemen 214, vorzugsweise einem Zahnriemen, in Eingriff steht. Dieser Zahnriemen ermöglicht eine Steuerung der Drehung des Kopfes 100, wie dies im folgenden anhand der Figur 3 noch näher erläutert wird.

Figur 3 zeigt eine Draufsicht auf eine Ausführungsform der Vorrichtung, bei der der Kopf 100 an einem aus zwei Abschnitten 200a und 200b bestehenden Tragarm befestigt ist. Die beiden Abschnitte des Tragarms sind um eine Schwenkachse 204 gegeneinander verschwenkbar, so daß sich ein Gelenkarm bildet und das freie Ende des ersten Abschnittes 200a ist um eine Schwenkachse 203a verschwenkbar, die an einer höhenverstellbaren Halterung 202 befestigt ist. Diese Halterung 202 kann beispielsweise mit Hilfe eines Stativs oder eines Ständers 210 auf einer Grundplatte 201 befestigt sein. Das freie Ende des zweiten Abschnittes 200b des Tragarms trägt, wie bereits erläutert, den Kopf 100, der um eine Schwenkachse 103 verschwenkbar ist, die konzentrisch zur Achse der Hohlwelle 302 bzw. der Antriebswelle 305 nach Figur 2 verläuft.

An der Halterung 202 ist eine Riemenscheibe 203 drehfest befestigt, deren Achse mit der Schwenkachse 203a zusammenfällt. Zwei weitere Riemenscheiben 211a, 211b sind auf der die beiden Abschnitte 200a und 200b miteinander verbindenden Schwenkachse 204 frei drehbar angeordnet, während an der Antriebswelle 305 eine aus Figur 2 ersichtliche Riemenscheibe 212 befestigt ist. Die Riemenscheiben 211a und 203 weisen den gleichen Durchmesser auf und sie sind über einen Riemen 213 miteinander verbunden. Die mit der Riemenscheibe 211a dezentrisch und drehfest verbundene Riemenscheibe 211b weist den gleichen Durchmesser auf wie die auf der Antriebswelle 305 des Kopfes befestigte Riemenscheibe 212 und die Riemenscheiben 211b und 212 sind über einen Riemen 214 miteinander verbunden. Die Riemenscheiben können vorzugsweise als Zahnriemenscheiben ausgebildet sein, wobei die Riemen 213 und 214 als Zahnriemen ausgebildet sind. Jede andere Art von bekannten Riemenscheiben und Riemen ist selbstverständlich ebenfalls verwendbar.

Durch diese Verbindung der Riemenscheiben und Riemen miteinander ergibt sich beim Bewegen des Kopfes zwischen einem Bauelemente-Vorratsbereich 205 und einem Arbeitsbereich 206 auf der Grundplatte 201 eine exakte Parallelführung der Bauelemente, so daß eine automatische Steuerung der Bewegung des Kopfes möglich ist. Aus Figur 3 ist weiterhin die Anordnung der Heizplatte 111 auf der Grundplatte 201 ersichtlich. Aus einem Vorratsbehälter 205 aufgenommene Bauelemente können damit unter exakter Parallelführung auf eine auf der Heizplatte 111 angeordnete Leiterplatte überführt werden, wobei eventuelle Fehlausrichtungen mit Hilfe des in Figur 1 gezeigten Drehknopfes 109 korrigiert werden können.

Selbstverständlich kann der in Figur 3 dargestellte Arm 200 auch als starrer Arm ausgeführt sein, wobei lediglich der Kopf die in den Figuren 1 und 2 dargestellten Heb- und Drehmöglichkeiten aufweist.

In Figur 4 ist eine ausführlichere Ansicht des unteren Endes des Kopfes gemäß Figur 1 dargestellt. In Figur 4 ist wiederum eine ebenfalls in Figur 5 gezeigte Leiterplatte 112 dargestellt, die selbstverständlich auch eine Hybridschaltung oder dergleichen sein kann, auf der ein Bauelement 113 befestigt werden soll. Dieses Bauelement weist an zwei gegenüberliegenden Seiten Anschlüsse 113a auf und es wird am unteren Ende 104a einer Vakuumpinzette mit Hilfe eines Saugnapfes 104b gehalten. Wie auch aus einer Betrachtung der Figur 1 zu erkennen ist, sind symmetrisch zur Vakuumpinzette zwei Heißluftdüsen angeordnet, deren untere Enden 102 aus den Figuren 4 und 5 ersichtlich sind. Diese unteren Enden 102 weisen eine der Erstreckung der Anschlüsse 113a an dem Bauelement 113 entsprechende langgestreckte Austrittsöffnung 102a auf, deren dem Bauelement zugewandter Rand durch einen Auflagesteg 102b verlängert ist, der einerseits die Anschlüsse gegen die Leiterplatte drückt und andererseits das Bauelement 113 gegen den aus der Heißluftdüse austretenden Heißluftstrom abschirmt. Auf diese Weise wird ein Schutz des Bauelementes gegen eine unzulässige Erwärmung erzielt.

Wie insbesondere aus Figur 5 zu erkennen ist, erstreckt sich der Auflagesteg über die volle Breite des Bauelementes 113, wobei jedoch zur Vereinfachung der Darstellung in Figur 5 nur eine Heißluftdüse dargestellt ist. Sofern das Bauelement 113 nach Figur 5 an allen vier Seitenkanten Anschlüsse aufweist, so würden vier paarweise angeordnete Heißluftdüsen am unteren Ende des Kopfes symmetrisch um die Vakuumpinzette herum angeordnet sein, um ein gleichzeitiges Verlöten aller Anschlußreihen zu ermöglichen. Selbstverständlich ist jedoch auch möglich, bei Verwendung von zwei Heißluftdüsen den Kopf nach dem Verlöten zweier gegenüberliegender Anschlußreihen um 90° zu schwenken, um die verbleibenden Anschlußreihen zu verlöten.

Die beschriebene Vorrichtung ermöglicht eine sehr schnelle und zuverlässige Befestigung von selbst sehr kleinen Bauelementen auf einer Leiterplatte oder einer Hybridschaltung, ohne daß die Gefahr eines Verrutschens oder einer fehlerhaften Befestigung der Bauelemente auf der Leiterplatte besteht. Dies ist insbesondere auch deshalb der Fall, weil der Andruck der Auflagestege 102b nach dem Lötvorgang bis zum Erkalten des Lotes aufrechterhalten werden kann, so daß sich keine Gefahr einer kalten Lötstelle ergibt.

Der Auflagesteg 102b ist für Lot unbeneztbar und schlecht wärmeleitend, so daß eine Wärmeabfuhr von der Lötstelle verhindert wird.

Selbstverständlich kann die Form der Heißluftdüsen sowie des Saugnapfes 104b bei anderen Formen von zu befestigenden Bauelementen entsprechend angepaßte Formen aufweisen, die sich direkt aus der Formgebung der Bauelemente ergeben.

## Patentansprüche

1. Vorrichtung zum Löten und Entlöten von oberflächenmontierten Bauelementen auf Leiterplatten oder Hybridschaltungen mit Hilfe eines Heißluftstromes, wobei in in Vertikalrichtung beweglicher Kopf (100) vorgesehen ist, der an seinem unteren Ende eine Vakuumpinzette (103, 104) zur Halterung eines Bauelementes (113) und mindestens eine Heißluftdüse (101, 102) trägt, dadurch gekennzeichnet, daß das freie Ende der Heißluftdüse gegenüber dem das Bauelement (113) halternden Ende der Vakuumpinzette (103, 104) verschwenkbar ist, um den Abstand zwischen dem Mittelpunkt der Vakuumpinzette und der Austrittsöffnung der Heißluftdüse zu ändern.

2. Vorrichtung nach Anspruch 1, dadurch gekennzeichnet, daß die Vakuumpinzette (103, 104) mit Hilfe einer Antriebseinrichtung (107 bis 109, 115 bis 118) um ihre Längsachse drehbar ist.

3. Vorrichtung nach Anspruch 1 oder 2, dadurch gekennzeichnet, daß die Vakuumpinzette (103, 104) in Vertikalrichtung gegenüber dem Kopf (100) und der mit diesem verbundenen mindestens einen Heißluftdüse (101, 102) nach unten hin elastisch vorgespannt ist.

4. Vorrichtung nach einem der vorhergehenden Ansprüche, dadurch gekennzeichnet, daß ein Handgriff (108) zur manuellen Betätigung des Kopfes (100) vorgesehen ist.

5. Vorrichtung nach einem der vorhergehenden Ansprüche, dadurch gekennzeichnet, daß zwei symmetrisch auf beiden Seiten der Vakuumpinzette (103, 104) angeordnete Heißluftdüsen (101, 102) vorgesehen sind, daß die Heißluftdüsen (101, 102) mit ihren oberen Enden an im Kopf (100) angeordneten Schwenkkörpern (106) befestigt sind, die um horizontale Schwenkachsen (106a) schwenkbar sind, und daß Einstelleinrichtungen (105, 106) zum Verschwenken der Schwenkkörper (106) um ihre Schwenkachsen (106a) vorgesehen sind.

6. Vorrichtung nach einem der vorhergehenden Ansprüche, dadurch gekennzeichnet, daß der Kopf (100) am Ende eines Tragarms (200) um eine vertikale Achse drehbar und heb- und senkbar befestigt ist.

7. Vorrichtung nach Anspruch 6, dadurch gekennzeichnet, daß der Tragarm (200) aus zwei um eine erste vertikale Schwenkachse (204) gegeneinander verschwenkbaren Abschnitten (200a, 200b) besteht, daß das freie Ende des ersten Abschnittes (200a) an einer höhenverstellbaren Halterung (202) um eine zweite Schwenkachse (203a) schwenkbar befestigt ist, und daß das freie Ende des zweiten Abschnittes (200b) den Kopf (100) über eine drehbare Welle (305) trägt.

8. Vorrichtung nach Anspruch 7, dadurch gekennzeichnet, daß eine erste und eine zweite Riemenscheibe (211a, 211b) drehfest miteinander verbunden und auf der ersten Schwenkachse (204) drehbar befestigt sind, daß eine dritte Riemenscheibe (203) drehfest mit der Halterung (202) verbunden ist, daß die Achse der dritten Riemenscheibe mit der zweiten Schwenkachse (203a) zusammenfällt, daß auf der drehbaren Welle (305) eine vierte Riemenscheibe (212) drehfest befestigt ist und daß die erste und die dritte Riemenscheibe (211a, 203) und die zweite und vierte Riemenscheibe (211b, 212) gleiche Durchmesser aufweisen und über jeweilige Antriebsriemen (213, 214) miteinander verbunden sind.

9. Vorrichtung nach Anspruch 8, dadurch gekennzeichnet, daß die ersten bis vierten Riemenscheiben (211a, 211b, 203, 212) Zahnriemenscheiben sind und daß die Antriebsriemen (213, 214) Zahnriemen sind.

10. Vorrichtung nach einem der Ansprüche 6 bis 9, dadurch gekennzeichnet, daß der Kopf (100) zwischen einem Bauelement-Vorratsbereich (205) und einem Arbeitsbereich (206) verschwenkbar ist.

11. Vorrichtung nach einem der Ansprüche 7 bis 10, dadurch gekennzeichnet, daß der Kopf (100) an seinem oberen Ende eine Schiebewelle (302) trägt, die im Inneren der Drehwelle (305) in Vertikalrichtung verschiebbar und mit dieser drehfest verbunden ist.

12. Vorrichtung nach einem der vorhergehenden Ansprüche, _dadurch gekennzeichnet_, daß die Austrittsöffnung (102a) der Heißluftdüsen (102) in einer Richtung langgestreckt ist, die senkrecht zur Verbindungslinie zwischen der Heißluftdüse (102) und der Vakuumpinzette (104) verläuft, und daß der der Vakuumpinzette zugewandte Rand der Austrittsöffnung (102a) nach unten hin durch einen Auflagesteg (102b) verlängert ist.

13. Vorrichtung nach Anspruch 12, _dadurch gekennzeichnet_, daß der Auflagesteg (102b) beim Lötvorgang zwischen der Austrittsöffnung (102a) und dem Hauptteil des Bauteils (113) liegt.

14. Vorrichtung nach einem der Ansprüche 12 oder 13, _dadurch gekennzeichnet_, daß der Auflagesteg (102b) für Lot unbenetzbar ist.

15. Vorrichtung nach einem der Ansprüche 12 bis 14, _dadurch gekennzeichnet_, daß der Auflagesteg (102b) schlecht wärmeleitend ist.

16. Vorrichtung nach einem der Ansprüche 12 bis 15, _dadurch gekennzeichnet_, daß der Auflagesteg (102b) eine geringe Wärmespeicherkapazität aufweist.

## Claims

1. Appliance for soldering and desoldering surface mounted components on printed circuit boards or hybrid circuits, said appliance functioning by means of a stream of hot air and being provided with a head (100) which can be moved in the vertical direction and, at its lower end, carries a vacuum tweezer (103, 104) and one or more hot air nozzles (101, 102), the purpose of the vacuum tweezer being to hold a component (113), characterized in that the free end of the hot air nozzle can be repositioned by being swung relative to that end of the vacuum tweezer (103, 104) which holds the component (113), so as to vary the distance between the central point of the vacuum tweezer and the outlet opening of the hot air nozzle.

2. Appliance according to Claim 1, characterized in that the vacuum tweezer (103, 104) can be rotated about its lengthwise axis with the aid of a drive system (107 to 109, 115 to 118).

3. Appliance according to Claim 1 or 2, characterized in that the vacuum tweezer (103, 104) is resiliently preloaded in the vertically downward direction relative to the head (100) and the one or more hot air nozzles (101, 102) connected thereto.

4. Appliance according to any one of the preceding Claims, characterized in that a handle (108) is provided for operating the head (100) manually.

5. Appliance according to any one of the preceding Claims, characterized in that two hot air nozzles (101, 102) are provided, symmetrically arranged on both sides of the vacuum tweezer (103, 104), in that the upper ends of the hot air nozzles (101, 102) are attached to swinging bodies (106) which are installed inside the head (100) and can be repositioned by being swung about horizontal pivot pins (106a), and in that adjusting facilities (105, 106) are provided for repositioning the swinging bodies (106) by swinging them about their pivot pins (106a).

6. Appliance according to any one of the preceding Claims, characterized in that the head (100) is attached to the end of a cantilever arm (200) in a manner such that it can be rotated about a vertical axis and be lifted and lowered.

7. Appliance according to claim 6, characterized in that the cantilever arm (200) comprises two portions (200a, 200b) which can be slewed, relative to each other, about a first, vertical slewing pivot (204), in that the free end of the first portion (200a) is attached to a vertically adjustable holding fixture (202) in a manner such that said portion can slew about a second slewing pivot (203a), and in that the free end of the second portion (200b) carries the head (100) via a rotatable shaft (305).

8. Appliance according to Claim 7, characterized in that first and second belt pulleys (211a, 211b) are coupled together in a manner such that they cannot rotate relative to each other, and are installed on the first slewing pivot (204) in a manner such that they can rotate thereon, in that a third belt pulley (203) is attached to the holding fixture (202) in a manner such that it cannot rotate relative thereto, in that the axis of the third belt pulley coincides with the second slewing pivot (203a), in that a fourth belt pulley (212) is installed on the rotatable shaft (305) in a manner such that it cannot rotate relative thereto, and in that the first and third belt pulleys (211a, 203) are of the same diameter and are interconnected by a drive belt (213) and the second and fourth belt pulleys (211b, 212) are of the same diameter and are interconnected by a drive belt (214).

9. Appliance according to Claim 8, characterized in that the first to fourth belt pulleys (211a, 211b, 203, 212) are toothed-belt pulleys, and in that the drive belts (213, 214) are of the toothed type.

10. Appliance according to any one of Claims 6 to 9, characterized in that the head (100) can be swung between a component storage area (205) and a working area (206).

11. Appliance according to any one of Claims 7 to 10, characterized in that the head (100) carries a sliding shaft (302) at its upper end, this shaft being slidably displaceable in the vertical direction within the rotatable shaft (305), to which it is connected in a manner such that it cannot rotate relative thereto.

12. Appliance according to any one of the preceding Claims, characterized in that the outlet opening (102a) of each of the hot air nozzles (102) is elongated in a direction perpendicular to the connecting line between the hot air nozzle (102) and the vacuum tweezer (104), and in that the outlet-opening edge facing the vacuum tweezer is extended downwards by a supporting fin (102b).

13. Appliance according to Claim 12, characterized in that during the soldering operation, the supporting fin (102b) is located between the outlet opening (102a) and the main part of the component (113).

14. Appliance according to Claim 12 or 13, characterized in that the supporting fin (102b) is unwettable by solder.

15. Appliance according to any one of claims 12 to 14, characterized in that the supporting fin (102b) is a poor conductor of heat.

16. Appliance according to any one of claims 12 to 15, characterized in that the supporting fin (102b) has a low heat-storage capacity.

## Revendications

1. Dispositif pour souder et dessouder des éléments constructifs montés en surface sur plaquettes à circuits imprimés ou circuits hybrides à l'aide d'un courant d'air chaud présentant une tête (100) pouvant se déplacer en direction verticale et portant, à son extrémité inférieure, une pincette à vide (103, 104) pour maintenir un élément constructif (113) et au moins une tuyère à air chaud (101, 102), caractérisé en ce que l'extrémité libre de la tuyère à air chaud peut pivoter par rapport à l'extrémité de la pincette à vide (103, 104) maintenant l'élément constructif (113) afin de modifier la distance entre le centre de la pincette à vide et l'orifice de sortie de la tuyère à air chaud.

2. Dispositif selon la revendication 1, caractérisé en ce que la pincette à vide (103, 104) peut pivoter autour de son axe longitudinal à l'aide d'un dispositif de commande (107 à 109, 115 à 118).

3. Dispositif selon la revendication 1 ou 2, caractérisé en ce que la pincette à vide (103, 104) est maintenue par poussée élastique vers le bas en direction verticale par rapport à la tête (100) et à au moins une tuyère à air chaud (101, 102) reliée à celle-ci.

4. Dispositif selon l'une des revendications précédentes, caractérisé en ce qu'une poignée (108) est prévue pour actionner manuellement la tête (100).

5. Dispositif selon l'une des revendications précédentes, caractérisé en ce que deux tuyères à air chaud (101, 102) sont prévues des deux côtés de la pincette à vide (103, 104), que les tuyères à air chaud (101, 102) sont fixées par leurs extrémités supérieures à des corps pivotants (106) disposés dans la tête (100) et qui peuvent pivoter autour d'axes de pivotement horizontaux (106a) et que des dispositifs de réglage (105, 106) sont prévus pour faire pivoter les corps pivotants (106) autour de leurs axes de pivotement (106a).

6. Dispositif selon l'une des revendications précédentes, caractérisé en ce que la tête (100) est fixée à l'extrémité d'un bras de support (200) de manière à pouvoir tourner, monter et descendre autour d'un axe vertical.

7. Dispositif selon la revendication 6, caractérisé en ce que le bras de support (200) est constitué de deux sections (200a, 200b) pouvant pivoter l'une par rapport à l'autre autour d'un premier axe de pivotement vertical (204), que l'extrémité libre de la première section (200a) est fixée, avec possibilité de pivotement, autour d'un second axe de pivotement (203a) sur un support (202) pouvant être réglé en hauteur, et que l'extrémité libre de la seconde section (200b) porte la tête (100) par l'intermédiaire d'un arbre pivotant (305).

8. Dispositif selon la revendication 7, caractérisé en ce qu'une première et une seconde poulies (211a, 211b) sont assemblées l'une à l'autre sans possibilité de rotation et sont fixées avec possibilité de rotation sur le premier axe de pivotement (204), qu'une troisième poulie (203) est assemblée au support (202) sans possibilité de rotation, que l'axe de la troisième poulie coïncide avec le deuxième axe de pivotement (203a), qu'une quatrième poulie (212) est fixée sans possibilité de rotation sur l'arbre pivotant (205) et que la première et la troisième poulies (211a, 203) et la deuxième et la quatrième poulies (211b, 212) présentent des diamètres identiques et sont reliées les unes aux autres au moyen de courroies de transmission (213, 214).

9. Dispositif selon la revendication 8, caractérisé en ce que les quatre poulies (211a, 211b, 203, 212) sont des poulies pour courroies crantées et que les courroies de transmission (213, 214) sont des courroies crantées.

10. Dispositif selon l'une des revendications 6 à 9, caractérisé en ce que la tête (100) peut pivoter entre une zone d'alimentation d'éléments constructifs (205) et une zone de travail (206).

11. Dispositif selon l'une des revendications 7 à 10, caractérisé en ce que la tête (100) porte, à son extrémité supérieure, un arbre coulissant (302) qui peut coulisser en direction verticale à l'intérieur de l'arbre rotatif (305) et est assemblé à celui-ci sans possibilité de rotation.

12. Dispositif selon l'une des revendications précédentes, caractérisé en ce que l'orifice de sortie (102a) des tuyères à air chaud (102) s'étend dans une direction qui est perpendiculaire à la ligne joignant la tuyère à air chaud (102) et la pincette à vide (104) et que le bord de l'orifice de sortie (102a) tourné vers la pincette à vide est prolongé vers le bas par un rebord (102b).

13. Dispositif selon la revendication 12, caractérisé en ce que le rebord (102b) est situé entre l'orifice de sortie (102a) et la partie principale de l'élément constructif (113) au cours de l'opération de soudure.

14. Dispositif selon l'une des revendications 12 ou 13, caractérisé en ce que le rebord (102b) ne peut pas être mouillé par la soudure.

15. Dispositif selon l'une des revendications 12 à 14, caractérisé en ce que le rebord (102b) est un médiocre conducteur de la chaleur.

16. Dispositif selon l'une des revendications 12 à 15, caractérisé en ce que le rebord (102b) présente une faible capacité d'accumulation de la chaleur.

# FIG. 1

# FIG. 2

# FIG. 3

# FIG. 4

# FIG. 5